# EUROPÄISCHE PATENTANMELDUNG

(11) **EP 2 450 923 A2**
(43) Veröffentlichungstag der Anmeldung: **09.05.2012**
(21) Anmeldenummer: 11185535.9
(22) Anmeldetag: 18.10.2011
(51) Int. Cl.: H01G 2/10, H01G 2/00, H01G 2/02

(54) **Kondensatorsystem und Verfahren zur Herstellung eines Kondensatorsystems**

(30) Priorität: 05.11.2010 DE 102010043455
(71) Anmelder: SEMIKRON Elektronik GmbH & Co. KG, 90431 Nürnberg (DE)
(72) Erfinder: Beckedahl, Peter, 90522 Oberasbach (DE); Ebersberger, Frank, 90518 Altdorf (DE); Kulas, Hartmut, 91320 Ebermannstadt (DE); Schott, Peter, 90491 Nürnberg (DE)

(57) **Zusammenfassung**

Die Anmeldung betrifft ein Kondensatorsystem (100) sowie ein Verfahren zur Herstellung eines Kondensatorsystems (100), insbesondere ein Kondensatorsystem bzw. eines Kondensatorsystems eines Leistungshalbleitermoduls. In einer Ausführungsform betrifft die Anmeldung ein Kondensatorsystem (100) mit einem eine Vertiefung (11) aufweisenden Metallformkörper (10); einem zumindest teilweise in der Vertiefung (11) angeordneten Kondensator (20); einem zumindest teilweise zwischen dem Kondensator (20) und dem Metallformkörper (10) in der Vertiefung angeordneten Abstandshalter (30) aus elektrisch isolierendem Material; und einem in der Vertiefung (11) vorgesehenen, elektrisch isolierenden Vergussmaterial (40), wobei das Vergussmaterial (40) den Kondensator (20) derart in der Vertiefung (11) befestigt, dass der Kondensator (20) den Metallformkörper (10) nicht berührt.

## Beschreibung

Die vorliegende Erfindung betrifft ein Kondensatorsystem sowie ein Verfahren zur Herstellung eines Kondensatorsystems, insbesondere ein Kondensatorsystem bzw. eines Kondensatorsystems eines Leistungshalbleitermoduls.

Kondensatoren werden in der Leistungselektronik unter anderem in Spannungszwischenkreisen von Umrichtern oder als Filterkondensatoren eingesetzt. Die Anforderungen an derartige leistungselektronische Systeme hinsichtlich der Herstellungskosten, der Größe und Zuverlässigkeit des Systems steigen stetig. In diesem Zusammenhang wird in EP 0 994 494 ein niederinduktiv aufgebauter Folienkondensator vorgestellt, der in einen Zwischenkreisaufbau von Umrichtern integriert werden kann und dazu geeignet ist, eine kompakte und zuverlässige Aufbauweise zu ermöglichen. Dabei wird insbesondere ein einseitiges Kontaktieren des Kondensators zwecks eines passgenauen Aufsetzens auf Kühlflächen gelehrt.

Der Erfindung liegt die Aufgabe zugrunde, ein verbessertes Kondensatorsystem sowie ein Verfahren zur Herstellung eines verbesserten Kondensatorsystems aufzuzeigen.

Die vorliegende Offenbarung schlägt unter anderem vor, ein gehäuseloses Kondensatorgebilde mittels einer Vergussmasse in einer wannenförmigen Vertiefung eines für die Kühlung einer Leistungshalbleiterschaltung geeigneten, metallischen Kühlkörpers zu befestigen, wobei das Kondensatorgebilde in einem korbförmigen, als Abstandshalter fungierenden Kunststoffrahmen angeordnet wird und die Vergussmasse das Kondensatorgebilde, im weiteren nur noch als Kondensator bezeichnet, gegenüber dem Kühlkörper elektrisch isoliert. Hierdurch wird ein kompakter Aufbau ermöglicht.

Die vorliegende Offenbarung betrifft unter anderem ein Kondensatorsystem, insbesondere ein Kondensatorsystem eines Leistungshalbleitermoduls.

Das Kondensatorsystem weist einen eine Vertiefung aufweisenden Metallformkörper, einen zumindest teilweise in der Vertiefung angeordneten Kondensator und ein in der Vertiefung vorgesehenes, elektrisch isolierendes Vergussmaterial auf, das den Kondensator derart in der Vertiefung anordnet, dass der Kondensator den Metallformkörper nicht berührt und somit elektrisch von diesem isoliert ist.

Der Metallformkörper begünstigt den Abtransport von Wärme, die sich im Kondensator entwickelt. Alternativ könnte dieser Metallformkörper allerdings auch aus einem vergleichbar robustem und Wärme leitendem nicht metallischen Werkstoff bestehen.

Unter Vergussmaterial wird im weiteren ein Material verstanden, das von einem flüssigen Zustand in einen dauerhaft festen Zustand, häufig als "ausgehärteten" Zustand bezeichnet, umgewandelt werden kann. Diese Umwandlung kann passiv erfolgen, beispielsweise durch eine chemische Reaktion des flüssigen Vergussmaterials mit der Luft, oder auch aktiv herbeigeführt werden, beispielsweise durch die Beigabe eines chemischen Reaktanten zum flüssigen Vergussmaterial oder durch Bestrahlung des flüssigen Vergussmaterials mit UV-Licht. Diese Umwandlung, häufig "Aushärtung" genannt, dauert üblicherweise mehrere Sekunden bis einige Stunden.

Das Vergussmaterial kann ein Material sein, das trotz seiner elektrisch isolierenden Eigenschaft eine bessere, beispielsweise um einen Faktor 10 bis 100 bessere, Wärmeleitfähigkeit als Luft ausweist. Somit kann das Vergussmaterial sowohl dazu dienen, den Kondensator vom Metallformkörper elektrisch zu isolieren, als auch dazu, einen durchgehenden Wärmeübergang zwischen dem Kondensator und dem Metallformkörper in einfacher Art und Weise herzustellen. Diese elektrische Isolierung wird sowohl durch die durch das Vergussmaterial, nach seiner Aushärtung, dauerhaft gewährleistete Positionierung des Kondensators an einer vom Metallformkörper beabstandeten Position als auch durch die elektrisch isolierende Eigenschaft des Vergussmaterials erreicht. Hierbei ist anzumerken, dass das Vergussmaterial in flüssigem Zustand zwischen dem Kondensator und dem Metallformkörper eingebracht werden kann, um den Kondensator dann in ausgehärtetem Zustand gegenüber dem Metallformkörper zu fixieren.

Das Einbringen des flüssigen Vergussmaterials zwischen Kondensator und Metallformkörper kann dadurch erfolgen, dass das Vergussmaterial vor dem Kondensator in die Vertiefung eingebracht wird. Dabei wird das Vergussmaterial vom Kondensator beim Einbringen des Kondensators in die Vertiefung so verdrängt, dass das Vergussmaterial den Raum zwischen Kondensator und Metallformkörper teilweise bevorzugt aber vollständig, d.h. entsprechend der Menge des Vergussmaterials, füllt. Dieses Einbringen des flüssigen Vergussmaterials zwischen Kondensator und Metallformkörper kann ebenso dadurch erfolgen, dass das Vergussmaterial nach Einbringen des Kondensators in die Vertiefung ebenfalls in die Vertiefung in den Raum zwischen Kondensator und Metallformkörper eingegossen, unter Druck eingespritzt oder mittels Vakuum hinein gesogen wird. Für ein Einspritzen kann mindestens eine entsprechende Einspritzöffnung in einer Seitenwand der Vertiefung vorgesehen sein. Beim Einspritzen wird das Vergussmaterial aufgrund des angewendeten Drucks auch dann zwischen den Kondensator und den Metallformkörper gedrückt, wenn der Abstand zwischen Kondensator und Metallformkörper gering oder, beispielsweise an der durch das Vergussmaterial zwischen Kondensator und Metallformkörper zu erreichenden Spannungsfestigkeit gemessen, minimal ist.

Die Vertiefung stellt ein den Kondensator zumindest teilweise umgebendes Gehäuse dar und kann gleichzeitig als Gefäß zur Aufnahme des Vergussmaterials in flüssigem Zustand dienen, was die Herstellung des Kondensatorsystems vereinfachen kann. Entsprechend kann die Vertiefung wannenförmig sein. Die Vertiefung kann so groß sein, dass der Kondensator, gegebenenfalls zusammen mit einem wie unten beschriebenen Abstandshalter, vollständig darin aufgenommen werden kann, oder lediglich so groß sein, um lediglich einen Teil des Kondensators aufzunehmen. Die jeweiligen Ausmaße der Vertiefung sollen so dimensioniert sein, dass eine Aufnahme des Kondensators in der Vertiefung ohne Berührung des Kondensators mit dem Metallformkörper möglich ist. Die Vertiefung kann so dimensioniert sein, dass eine mit Ausnahme der Kondensatoranschlüsse vollständige Umhüllung des Kondensators mit Vergussmaterial innerhalb der Vertiefung möglich ist. Die Ausmaße der Vertiefung und somit der Abstand zwischen Kondensator und Metallformkörper sind so zu dimensionieren, dass sowohl eine durch das Vergussmaterial zwischen Kondensator und Metallformkörper zu erreichende Spannungsfestigkeit als auch eine durch das Vergussmaterial zwischen Kondensator und Metallformkörper zu erreichende Wärmeübertragung erreicht wird.

Das Kondensatorsystem kann einen zumindest teilweise zwischen dem Kondensator und dem Metallformkörper angeordneten Abstandshalter aus elektrisch isolierendem Material aufweisen. Der Abstandshalter kann zumindest teilweise in der Vertiefung zwischen dem Kondensator und dem Metallformkörper angeordnet sein. Der Abstandshalter kann somit zur korrekten Positionierung des Kondensators gegenüber dem Metallformkörper dienen, insbesondere während der Aushärtung des Vergussmaterials. Somit wird die Herstellung des Kondensatorsystems vereinfacht. Da der Abstandshalter aus elektrisch isolierendem Material gefertigt ist, wird die elektrische Isolierung des Kondensators gegenüber dem Metallformkörper erhalten.

Der Kondensator kann mindestens zwei metallische Kontaktelektroden und eine Aufschichtung mindestens zweier Elektroden und eines Dielektrikums aufweisen. Der Aufbau von Kondensatoren, die mehrere unmittelbar benachbart angeordnete Kondensatorschichten aufweisen, wobei jeder Kondensatorschicht ein zwischen zwei flächigen Elektroden angeordnetes Dielektrikum aufweist, ist dem Fachmann hinlänglich bekannt. Insbesondere kann das Dielektrikum durch eine Kunststofffolie oder ein ähnlich folienartiges, dielektrisches Material, (beispielsweise Isolierpapier, realisiert werden, weshalb ein derartiger Kondensator häufig als Folienkondensator bezeichnet wird. Die zugehörigen Elektroden können durch Bedampfung der Kunststofffolie mit einer Metallschicht realisiert werden. Ein Folienkondensator weist üblicherweise eine sehr kompakte Bauweise und eine für leistungselektronische Anwendung geeignet hohe Spannungsfestigkeit auf. Die Kontaktelektroden können unmittelbar an einer jeweiligen Außenfläche der Aufschichtung angeordnet sein. Hierdurch kann in einer dem Fachmann bekannten Weise eine Parallelverschaltung einiger oder aller einzelnen Kondensatorschichten erreicht werden. Die Kontaktelektroden können als Kondensatoranschlüsse zur Kontaktierung des Kondensators mit einer externen Schaltung dienen. Die mit den Kontaktelektroden elektrisch, regelmäßig auch niederohmig, verbundenen Kondensatoranschlüsse können aber auch separat von den Kontaktelektroden gebildet sein. Die Kontaktelektroden können mindestens einen Teil einer Außenfläche des Kondensators bilden.

Der Abstandshalter kann der Aufschichtung und/oder mindestens einer der Kontaktelektroden und/oder dem Metallformkörper unmittelbar benachbart sein. Der Abstandshalter kann mindestens eine Öffnung aufweisen, und das Kondensatorsystem kann so ausgebildet sein, dass das Vergussmaterial durch die Öffnung hindurch eine durchgehende Verbindung und damit ein Wärmeübergang zwischen dem Kondensator und dem Metallformkörper bildet. Der Abstandshalter kann ein zur passgenauen Aufnahme des Kondensators geformter Hohlkörper sein. Der Hohlkörper kann eine Wandstärke von weniger als 1 oder 2 mm aufweisen. Der Abstandshalter kann, zumindest im Wesentlichen, die Form eines quaderförmigen Korbs aufweisen. Der Abstandshalter kann Außenwände aufweisen, bei der die Öffnungen mehr als die Hälfte oder gar mehr als 80% oder 90% der Fläche der jeweiligen Außenwand ausmachen. Die Vertiefung kann zur passgenauen Aufnahme des Abstandshalters ausgebildet sein.

Die im vorhergehenden Absatz beschriebenen Merkmale tragen sowohl einzeln als auch synergetisch dazu bei, dass der Kondensator mit der für eine kommerzielle Fertigung notwendigen, reproduzierbaren Zuverlässigkeit sehr nah am Metallformkörper im Bereich der Vertiefung angeordnet werden kann, ohne dass stromführende Elemente des Kondensators mit dem Metallformkörper in Berührung kommen, und dass ein sehr guter Wärmeübergang zwischen dem Kondensator und dem Metallformkörper im Bereich der Vertiefung in ebenso zuverlässiger Weise hergestellt werden kann.

Die Vertiefung und der Abstandshalter können so ausgebildet sein, dass ein Teil des Abstandshalters auch dann aus der Vertiefung herausragt, wenn ein anderer Teil des Abstandshalters im Wesentlichen passgenau und so weit wie möglich in der Vertiefung angeordnet ist. Auf diese Weise kann insbesondere eine elektrische Isolierung zwischen dem Metallformkörper und denjenigen Teilen des Kondensators realisiert werden, die aus der Vertiefung bzw. aus dem Vergussmaterial herausragen. Der Abstandshalter kann Vorsprünge an einer aus der Vertiefung herausragenden Oberkante des Abstandshalters aufweisen, die im Wesentlichen senkrecht zu einer Seitenwand des Abstandshalters stehen. Derartige Vorsprünge können eine elektrisch isolierende Struktur bilden, die einen elektrischen Kontakt zwischen einer oberen Fläche des Metallformkörpers und den Kondensatoranschlüssen bzw. den mit den Kondensatoranschlüssen verbundenen Anschlüssen einer Leistungshalbleiterschaltung oder anderen stromführenden Leitungen verhindern.

Der Metallformkörper kann als Kühlkörper, beispielsweise als gerippter und/oder flüssigkeitsgekühlter Kühlkörper, beispielsweise als wassergekühlter Kühlkörper, gebildet sein. Das Kondensatorsystem kann Teil eines Leistungshalbleitermoduls mit einer Leistungshalbleiterschaltung sein. Das Kondensatorsystem kann Teil der Leistungshalbleiterschaltung sein. Die Leistungshalbleiterschaltung kann derart am Metallformkörper angeordnet sein, dass der Metallformkörper der Leistungshalbleiterschaltung als Kühlkörper dient. Der Metallformkörper und der Wärmeübergang zwischen dem Metallformkörper und der Leistungshalbleiterschaltung können derart ausgebildet sein, dass mindestens 70%, 80% oder gar 90% der im Nennbetrieb von der Leistungshalbleiterschaltung erzeugten Abwärme bei Kühlung des Metallformkörpers auf unter 40° C über den Metallformkörper abtransportiert werden kann.

Die Kontaktelektroden und die Kondensatorschichten eines Kondensators sind gemäß dem Stand der Technik meist in einem Gehäuse verkapselt, unter anderem um die Kondensatorschichten vor mechanischer Beschädigung und die Kontaktelektroden vor unerwünschtem elektrischem Kontakt zu schützen. So verkapselte Kondensatoren wurden dann als Einzelelemente verkauft und verbaut. Gemäß einer Lehre der vorliegenden Offenbarung wird auf eine derartige herstellerseitige Verkapselung des Kondensators verzichtet. Der somit ungehauste Kondensator wird stattdessen in einem Metallformkörper angeordnet, der den Kondensator nicht nur mechanisch schützt, sondern auch eine für die anwenderseitige Anwendung des Kondensators relevante Funktion erfüllt. Zum Beispiel kann der Metallformkörper als Kühlkörper für den Kondensator selbst und/oder für eine mit dem Kondensator verbundene Leistungshalbleiterschaltung fungieren. Auf diese Weise kann die Baugröße einer Leistungshalbleiterschaltung, die verhältnismäßig große Kondensatoren benötigt, deutlich verringert werden. Auch kann die Kühlung und die Montage einer derartigen Leistungshalbleiterschaltung mit großen Kondensatoren vereinfacht werden.

Wie oben beschrieben kann das Kondensatorsystem Teil eines Leistungshalbleitermoduls mit einer Leistungshalbleiterschaltung sein. Dabei kann die Leistungshalbleiterschaltung Kontaktanschlüsse aufweisen, die direkt mit den Kontaktelektroden des Kondensators elektrisch leitend verbunden, vorzugsweise verschweißt, sind. Auf diese Weise wird die Montage einer derartigen Leistungshalbleiterschaltung mit großen Kondensatoren vereinfacht. Aufgrund der Nähe zwischen der Leistungshalbleiterschaltung und dem Kondensator, die eine derartige Verschweißung zwangsläufig bedingt, wird zudem ein gemeinsames Kühlen der Leistungshalbleiterschaltung und des Kondensators begünstigt, ohne dass die Baugröße des Leistungshalbleitermoduls unverhältnismäßig zunehmen muss.

Eine Leistungshalbleiterschaltung im Sinne der vorliegenden Offenbarung kann eine Schaltung mit mindestens einem Halbleiterbauelement mit einer Nennspannung von über 100 V oder gar über 600 V sein. Eine Leistungshalbleiterschaltung im Sinne der vorliegenden Offenbarung kann eine Schaltung sein, mit der ein Strompfad zwischen einem ersten Potential und einem zweiten Potential in Abhängigkeit von mindestens einem Steuersignal selektiv zwischen einem im Wesentlichen geschlossenen (niederohmigen) Zustand und einem im Wesentlichen offenen (hochohmigen) Zustand geschaltet werden kann, wobei eine Differenz zwischen dem ersten Potential und dem zweiten Potential mehr als 100 V oder gar mehr als 600 V beträgt oder wobei ein im geschlossenen Zustand regelmäßig über den Strompfad fließender Strom mehr als 100 A oder gar mehr als 1000 A beträgt.

Auch wenn die in dieser Offenbarung beschriebenen Merkmale in Zusammenhang mit einem Kondensatorsystem erläutert werden, sind sämtliche offenbarten Merkmale selbstverständlich als ebenfalls für ein Verfahren zur Herstellung eines Kondensatorsystems offenbart anzusehen.

Nachfolgend wird die Erfindung anhand von Ausführungsbeispielen beschrieben, die anhand der Abbildungen näher erläutert werden. Hierbei zeigen:

Figur 1 eine perspektivische Ansicht der Unterseite eines Metallformkörpers für ein Kondensatormodul gemäß einer ersten Ausführungsform;

Figur 2 eine erste perspektivische Ansicht der Oberseite des Metallformkörpers für ein Kondensatormodul gemäß der Ausführungsform nach Figur 1;

Figur 3 eine zweite perspektivische Ansicht der Oberseite eines Kondensatormoduls gemäß der Ausführungsform nach Figur 1;

Figur 4 einen schematischen Querschnitt durch einen Metallformkörper für ein Kondensatormodul gemäß der Ausführungsform nach Figur 1; und

Figur 5 eine schematische Explosionszeichnung eines Kondensatormoduls gemäß der Ausführungsform nach Figur 1.

In der nachfolgenden Beschreibung werden für gleiche und gleich wirkende Teile dieselben Bezugsziffern verwendet.

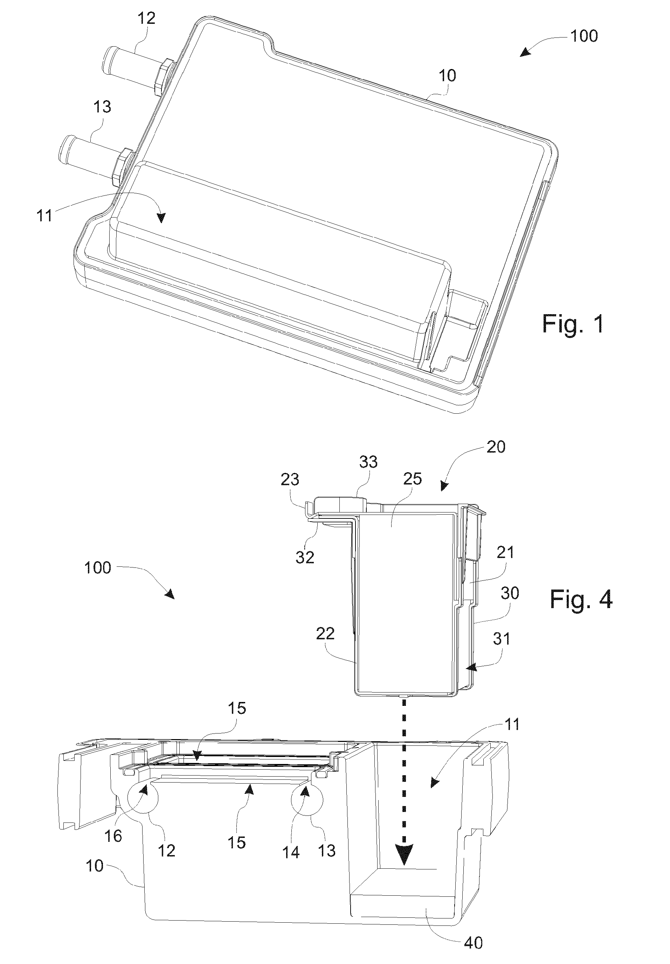

Die Figur 1 zeigt eine perspektivische Ansicht der Unterseite eines Metallformkörpers 10 für ein Kondensatormodul 100 gemäß einer ersten Ausführungsform, deren einzelne Elemente abweichend von den Zeichnungen auch eine wie oben beschriebene Ausgestaltung annehmen können. Der gezeigte Metallformkörper 10 weist eine Vertiefung 11 auf, die zur Aufnahme eines in der Figur 1 nicht gezeigten Kondensators 20 ausgebildet ist. Der Metallformkörper 10 ist als flüssigkeitsgekühlter Kühlkörper ausgebildet und weist zur Führung der Kühlflüssigkeit einen Flüssigkeitseinlass 12 sowie einen Flüssigkeitsauslass 13 auf.

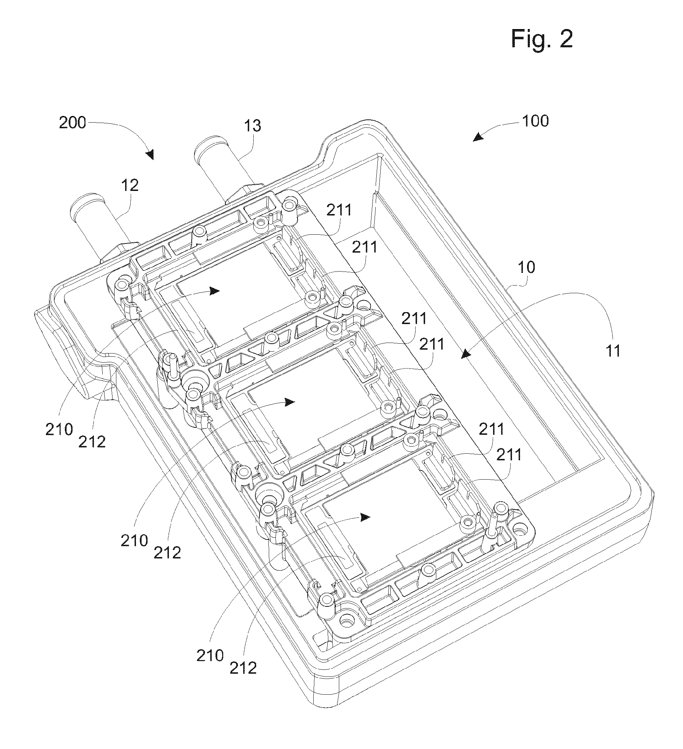

Die Figur 2 zeigt eine erste perspektivische Ansicht der Oberseite des Metallformkörpers 10 für ein Kondensatormodul 100 gemäß der Ausführungsform nach Figur 1, wobei das Kondensatormodul 100 einen Teil eines Leistungshalbleitermoduls 200 bildet. In diesem Sinne sind Leistungshalbleiterschaltungen 210 derart am Metallformkörper 10 angeordnet, dass der Metallformkörper 10 als Kühlkörper für die Leistungshalbleiterschaltungen 210 fungiert. Die Leistungshalbleiterschaltungen 210 weisen erste Anschlüsse 211 auf, über die ein direkter elektrischer Kontakt zu den in der Figur 2 nicht gezeigten, jeweiligen Kontakte 23, 24 des in der Figur 2 ebenfalls nicht gezeigten Kondensators 20 hergestellt werden kann. Die Leistungshalbleiterschaltungen 210 weisen auch zweite Anschlüsse 212 hier ausgebildet als Wechselspannungsanschluss.

In der Darstellung der Figur 2 ist das Kondensatormodul 100 noch nicht mit einem Kondensator 20 bestückt. Wie die Figur 1 zeigt die Figur 2 eine Vertiefung 11, die zur Aufnahme des in der Figur 2 nicht gezeigten Kondensators 20 ausgebildet ist, sowie einen Flüssigkeitseinlass 12 und einen Flüssigkeitsauslass 13 zur Durchleitung einer Kühlflüssigkeit zur Kühlung des Metallformkörpers 10.

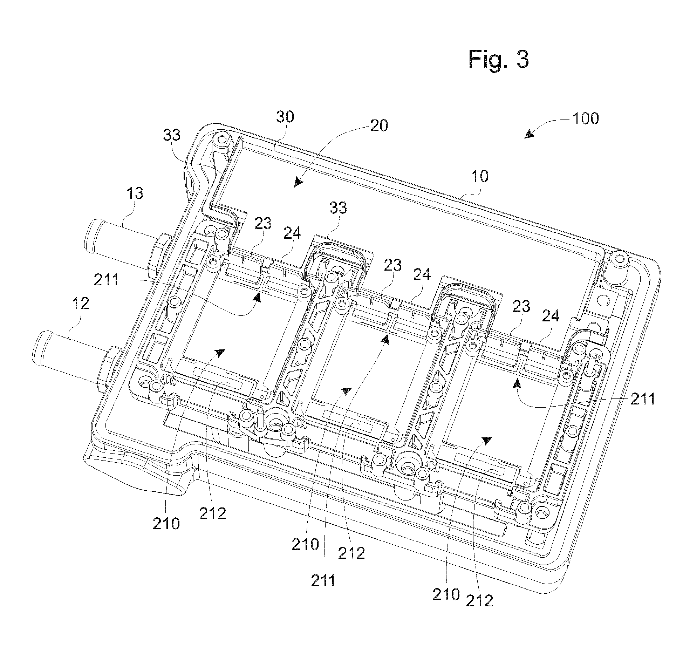

Die Figur 3 zeigt eine zweite perspektivische Ansicht der Oberseite eines Kondensatormoduls 100 gemäß der Ausführungsform nach Figur 1, wobei das Kondensatormodul 100 Teil eines Leistungshalbleitermoduls 200 bildet. Wie schon in der Figur 2 offenbart, sind Leistungshalbleiterschaltungen 210 in der Darstellung der Figur 3 derart am Metallformkörper 10 angeordnet, dass der Metallformkörper 10 als Kühlkörper für die Leistungshalbleiterschaltungen 210 fungiert. Die Leistungshalbleiterschaltungen 210 weisen erste Anschlüsse 211 auf, über die ein direkter elektrischer Kontakt, beispielsweise durch Verschweißung, zu den jeweiligen Kontakte 23, 24 des Kondensators 20 hergestellt werden kann.

Wie die Figuren 1 und 2 zeigt die Figur 3 einen Flüssigkeitseinlass 12 und einen Flüssigkeitsauslass 13 zur Führung einer Kühlflüssigkeit zur Kühlung des Metallformkörpers 10.

In der Darstellung der Figur 3 ist das Kondensatormodul 100 mit einem Kondensator 20 bestückt, der in einer in der Darstellung der Figur 3 nicht ersichtlichen Vertiefung 11 des Metallformkörpers 10 angeordnet ist.

Der Kondensator 20 ist in einem in der Darstellung der Figur 3 kaum ersichtlichen, korbförmigen Abstandshalter 30 aus elektrisch isolierendem Material angeordnet. Zudem ist der Kondensator 20 in einem in der Vertiefung 11 vorgesehenen, in der Darstellung der Figur 3 nicht sichtbaren, elektrisch isolierenden Vergussmaterial 40 derart eingedrückt, dass das Vergussmaterial 40 zusammen mit dem Abstandshalter 30 den Kondensator 20 mit Ausnahme der in Kondensatoranschlüsse 23, 24 vollständig umhüllt und elektrisch isoliert. Einige Abschnitte 33 des Abstandshalters 30 ragen über die obere Fläche des Vergussmaterials 40 hinaus und bieten somit einigen oberen Bereichen des Kondensators 20 mechanischen Schutz sowie eine weitere elektrische Isolierung.

Die Figur 4 zeigt einen schematischen Querschnitt durch einen Metallformkörper 10 für ein Kondensatormodul 100 gemäß der Ausführungsform nach Figur 1. Der Metallformkörper 10 ist mit einem Flüssigkeitseinlass 12 und einem Flüssigkeitsauslass 13 zur Führung einer Kühlflüssigkeit zur Kühlung des Metallformkörpers 10 versehen. Dabei kann die Kühlflüssigkeit vom Flüssigkeitseinlass 12 durch eine Öffnung 14 in einen Hohlraum 15 im Metallformkörper 10 einströmen und von dem Hohlraum 15 durch eine Öffnung 16 in den Flüssigkeitsauslass 13 strömen.

Der Metallformkörper 10 weist eine Vertiefung 11 auf, die zur Aufnahme eines in einem korbförmigen Abstandshalter 30 aus elektrisch isolierendem Material angeordneten Kondensators 20 ausgebildet ist. Die Vertiefung 11 ist teilweise mit einem elektrisch isolierenden, noch flüssigen Vergussmaterial 40 gefüllt, in das der Kondensator 20 zusammen mit dem Abstandshalter 30 eingedrückt werden kann. Dabei wird das Vergussmaterial 40 derart verdrängt, dass das Vergussmaterial 40 zusammen mit dem Abstandshalter 30 einen zusammenhängenden Bereich des Raumes zwischen dem Kondensator 20 und dem Metallformkörper 10 vollständig füllt. Wie groß dieser Bereich ist, hängt natürlich von der Menge des Vergussmaterials 40 ab. Ist ausreichend Vergussmaterial 40 in der Vertiefung 11 vorhanden, so wird der Kondensator 20 mit Ausnahme der Kondensatoranschlüsse 23, 24 vollständig umhüllt und elektrisch isoliert. Der Abstandshalter 30 weist einen Vorsprung 32 auf, der den Kondensatoranschluss 23 vom Metallformkörper 10 elektrisch isoliert. Einige Abschnitte 33 des Abstandshalters 30 ragen über die obere Fläche des Vergussmaterials 40 hinaus und bieten somit einigen oberen Bereichen des Kondensators 20 mechanischen Schutz sowie eine weitere elektrische Isolierung.

Der Kondensator 20 weist in einer wie oben beschriebenen Art mindestens zwei metallische Kontaktelektroden 21, 22 und eine Aufschichtung 25 mindestens zweier Elektroden und eines Dielektrikums. Die Kontaktelektroden 21, 22 bilden einen Teil der Außenfläche des Kondensators 20. Ein zungenförmiger Abschnitt der jeweiligen Kontaktelektrode 21, 22 dient als Kondensatoranschluss 23, 24.

Der Abstandshalter 30 ist als Hohlkörper zur passgenauen Aufnahme des Kondensators 20 gebildet. Ein Großteil der Außenwände des Abstandshalters 30 ist durch Öffnungen 31 geöffnet. Der Abstandshalter 30 weist folglich eine entsprechend korbförmige Gestalt auf. An einer Oberkante des Abstandshalters 30 sind optionale Vorsprünge 32 vorgesehen. Die Vorsprünge 32 können dazu dienen, stromführende Leitungen, die zwischen den jeweiligen Kondensatoranschlüssen 23, 24 und den — in der Figur 4 nicht dargestellten — jeweiligen Anschlüsse 211 einer Leistungshalbleiterschaltung 210 verlaufen, gegenüber dem Metallformkörper 10 elektrisch zu isolieren. Dass die Vorsprünge 32 am Abstandshalter 30 vorgesehen sind und somit nicht als separate Elemente an den Metallformkörper montiert werden müssen, vereinfacht die Montage des Leistungshalbleitermoduls 200.

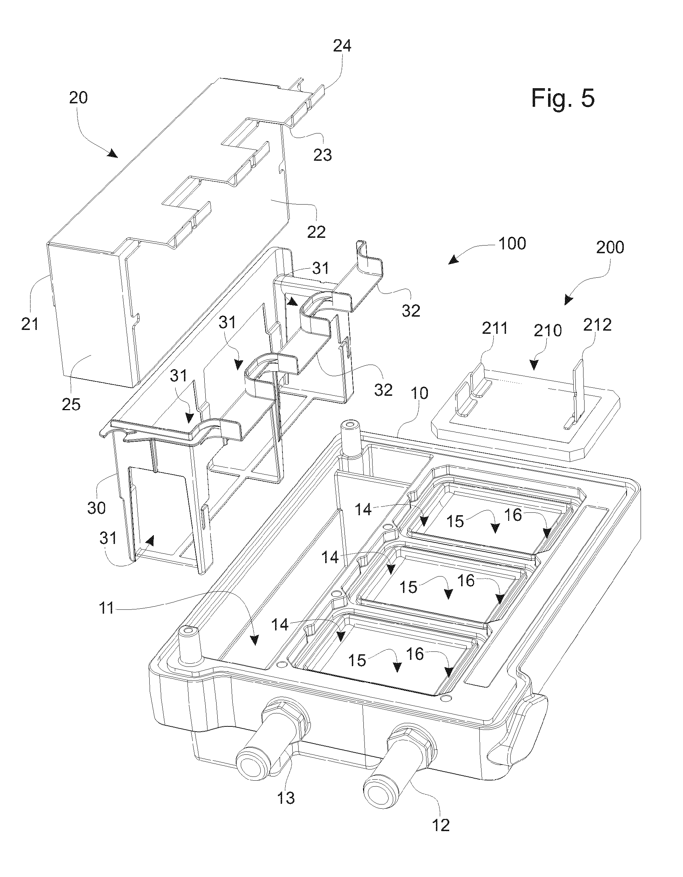

Die Figur 5 zeigt eine schematische Explosionszeichnung eines Kondensatormoduls 100 gemäß der Ausführungsform nach Figur 1, wobei das Kondensatormodul 100 Teil eines Leistungshalbleitermoduls 200 bildet. Das Kondensatormodul 100 weist einen Metallformkörper 10, einen Kondensator 20 und einen aus einem elektrisch isolierenden Material gefertigten Abstandshalter 30 auf.

Der Metallformkörper 10 weist eine Vertiefung 11 auf, die der Aufnahme des Kondensators 20 mit dem Abstandshalters 30 dient.

Wie in der Figur 5 dargestellt, können Leistungshalbleiterschaltungen 210 des Leistungshalbleitermoduls 200 derart am Metallformkörper 10 angeordnet werden, dass der Metallformkörper 10 als Kühlkörper für die Leistungshalbleiterschaltungen 210 fungiert. Dabei kann eine Kühlflüssigkeit, die dem Metallformkörper 10 über einen Flüssigkeitseinlass 12 zugeführt wird, über eine mittels einer nicht gezeigten, ersten Flüssigkeitsleitung mit dem Flüssigkeitseinlass 12 verbundene Einlassöffnung 14 in einen Hohlraum 15 des Metallformkörpers 10 strömen und über eine mittels einer nicht gezeigten, zweiten Flüssigkeitsleitung mit dem Flüssigkeitsauslass 13 verbundene Auslassöffnung 16 aus dem Hohlraum 15 des Metallformkörpers 10 wieder herausströmen. Eine von den stromführenden Elementen der Leistungshalbleiterschaltung 210 elektrisch isolierte Unterseite der Leistungshalbleiterschaltung 210 kann den Hohlraum 15 derart abdecken, dass die Kühlflüssigkeit entlang der Unterseite der Leistungshalbleiterschaltung 210 entlang strömt und dass die Kühlflüssigkeit nicht aus dem Hohlraum 15 heraus entweichen kann. Auf diese Weise wird ein sehr guter Abtransport der in der Leistungshalbleiterschaltung 210 entstehenden Abwärme ermöglicht.

Der Kondensator 20 weist in einer wie oben beschriebenen Art mindestens zwei metallische Kontaktelektroden 21, 22 und eine Aufschichtung 25 mindestens zweier Elektroden und eines Dielektrikums. Die Kontaktelektroden 21, 22 bilden einen Teil der Außenfläche des Kondensators 20. Ein zungenförmiger Abschnitt der jeweiligen Kontaktelektrode 21, 22 dient als Kondensatoranschluss 23, 24.

Der Abstandshalter 30 ist als Hohlkörper zur passgenauen Aufnahme des Kondensators 20 gebildet. Ein Großteil der Außenwände des Abstandshalters 30 ist durch Öffnungen 31 geöffnet. Der Abstandshalter 30 weist folglich eine entsprechend korbförmige Gestalt auf. An einer Oberkante des Abstandshalters 30 sind optionale Vorsprünge 32 vorgesehen. Die Vorsprünge 32 können dazu dienen, stromführende Leitungen, die zwischen den jeweiligen Kondensatoranschlüssen 23, 24 und den jeweiligen Anschlüsse 211 der Leistungshalbleiterschaltungen 210 verlaufen, gegenüber dem Metallformkörper 10 elektrisch zu isolieren. Dass die Vorsprünge 32 am Abstandshalter 30 vorgesehen sind und somit nicht als separate Elemente an den Metallformkörper montiert werden müssen, vereinfacht die Montage des Leistungshalbleitermoduls 200.

Das in der Figur 5 gezeigt Leistungshalbleitermodul 200 zeichnet sich durch eine sehr einfache Montage aus. In die Vertiefung 11 wird ein in der Figur 5 nicht gezeigtes Vergussmaterial 40 in der in Figur 4 beispielhaft gezeigte Weise eingebracht. Anschließend wird der Abstandshalter 30 zusammen mit dem Kondensator 20 in die Vertiefung 11 gedrückt. Während der Abstandshalter 30 verhindert, dass der Kondensator 20, dessen Außenflächen zumindest teilweise, wenn nicht sogar ganzflächig, stromführend sind, mit den Seitenwänden der Vertiefung 11, sprich mit dem Metallformkörper 10, in Berührung kommt, füllt das Vergussmaterial aufgrund der sich ergebenden Verdrängung durch den Abstandshalter 30 und dem Kondensator 20 den Raum zwischen Kondensator 20 und Metallformkörper 10. Der Kondensator 20 wird durch das Vergussmaterial 40 zusammen mit dem Abstandshalter 30 vom Metallformkörper 10 elektrisch isoliert. Nach Aushärtung des Vergussmaterials 40 sind der Kondensator 20 und der Abstandshalter 30 dauerhaft in der Vertiefung befestigt. In der in der Figur 5 dargestellten Ausführungsform sind die Kondensatoranschlüsse 23, 24 derart ausgebildet, dass diese nach Montage des Kondensators 20 in der Vertiefung 11 derart nahe an Anschlüssen 211 der am Metallformkörper 10 montierten Leistungshalbleiterschaltungen 210 angeordnet sind, dass die Kondensatoranschlüsse 23, 24 direkt mit den Anschlüssen 211 der Leistungshalbleiterschaltungen 210 verschweißt werden können, um einen elektrischen Kontakt zwischen dem Kondensator 20 und den Leistungshalbleiterschaltungen 210 herzustellen.

An dieser Stelle sei explizit darauf hingewiesen, dass die in den Figuren dargestellten Ausführungsformen in jede in dieser Offenbarung beschriebener Art abgewandelt werden können. An dieser Stelle sei zudem darauf hingewiesen, dass alle oben beschriebenen Merkmale für sich allein gesehen und in jeder Kombination, insbesondere die in den Zeichnungen dargestellten Details als erfindungswesentlich beansprucht werden können. Abänderungen hiervon sind dem Fachmann geläufig.

## Patentansprüche

1. Kondensatorsystem (100), mit
einem eine Vertiefung (11) aufweisenden Metallformkörper (10);
einem zumindest teilweise in der Vertiefung (11) angeordneten ungehausten Kondensator (20);
einem zumindest teilweise zwischen dem Kondensator (20) und dem Metallformkörper (10) in der Vertiefung (11) angeordneten Abstandshalter (30) aus elektrisch isolierendem Material; und
einem in der Vertiefung (11) vorgesehenen, elektrisch isolierenden Vergussmaterial (40), wobei der Abstandshalter (30) und
das Vergussmaterial (40) den Kondensator (20) derart in der Vertiefung (11) anordnet, dass der Kondensator (20) den Metallformkörper (10) nicht berührt und gegen den Metallformkörper (10) elektrisch isoliert.

2. Kondensatorsystem (100) nach Anspruch 1, wobei
der Kondensator (20) mindestens zwei metallische Kontaktelektroden (21, 22) und eine Aufschichtung (25) mindestens zweier Elektroden und eines Dielektrikums aufweist,
die Kontaktelektroden (21, 22) unmittelbar an einer jeweiligen Außenfläche der Aufschichtung (25) angeordnet sind, und
die Kontaktelektroden (21, 22) mindestens einen Teil einer Außenfläche des Kondensators (20) bilden.

3. Kondensatorsystem (100) nach Anspruch 2, wobei
der Abstandshalter (30) zu der Aufschichtung (25) und/oder mindestens zu einer der Kontaktelektroden (21, 22) und/oder zu dem Metallformkörper (10) unmittelbar benachbart ist.

4. Kondensatorsystem (100) nach einem der vorhergehenden Ansprüche, wobei
der Abstandshalter (30) mindestens eine Öffnung (31) aufweist,
das Vergussmaterial (40) durch die Öffnung (31) hindurch eine durchgehende Verbindung und damit einen Wärmeübergang zwischen dem Kondensator (20) und dem Metallformkörper (10) bildet.

5. Kondensatorsystem (100) nach einem der vorhergehenden Ansprüche, wobei der Abstandshalter (30) ein zur passgenauen Aufnahme des Kondensators (20) geformter Hohlkörper ist.

6. Kondensatorsystem (100) nach einem der vorhergehenden Ansprüche, wobei der Metallformkörper (10) ein wassergekühlter Kühlkörper ist.

7. Leistungshalbleitermodul (200) mit
einer Leistungshalbleiterschaltung (210); und
einem Kondensatorsystem (100) nach einem der vorhergehenden Ansprüche, wobei
der Metallformkörper (10) als Kühlkörper ausgebildet ist, und
die Leistungshalbleiterschaltung (210) zum Metallformkörper (10) angeordnet ist.

8. Leistungshalbleitermodul (200) nach Anspruch 7 abhängig vom Anspruch 2, wobei die Leistungshalbleiterschaltung (210) Kontaktanschlüsse (211) aufweist, die direkt mit den Kontaktelektroden (21, 22) des Kondensators (20) elektrisch leitend verbunden sind.

9. Verfahren zur Herstellung eines Kondensatorsystems (100) mit den folgenden Schritten:
● Anordnung eines Kondensators (20) in einem aus elektrisch isolierendem Material gefertigten Abstandshalter (30);
● Anordnung des Kondensators (20) zusammen mit dem Abstandshalter (30) zumindest teilweise in einer Vertiefung (11) eines Metallformkörpers (10); und
● Einbringen eines elektrisch isolierenden Vergussmaterials (40) in einen durch den Abstandshalter (30) zwischen dem Kondensator (20) und der Vertiefung (11) gebildeten Hohlraum.

10. Verfahren zur Herstellung eines Kondensatorsystems (100) mit den folgenden Schritten:
● Anordnung eines Kondensators (20) in einem aus elektrisch isolierendem Material gefertigten Abstandshalter (30);
● Einbringen eines elektrisch isolierenden Vergussmaterials (40) in eine Vertiefung (11) eines Metallformkörpers (10); und
● Anordnung des Kondensators (20) zusammen mit dem Abstandshalter (30) zumindest teilweise in der Vertiefung (11) des Metallformkörpers (10), wobei das Vergussmaterial (40) dabei in einen durch den Abstandshalter (30) zwischen dem Kondensator (20) und der Vertiefung (11) gebildeten Hohlraum fließt.

11. Verfahren nach Anspruch 9 oder 10, wobei
der Abstandshalter (30) gewährleistet, dass der Kondensator (20) bei der Anordnung des Kondensators (20) in der Vertiefung (11) des Metallformkörpers (10) diesen nicht berührt.

12. Verfahren nach einem der Ansprüche 9-11, wobei
der Abstandshalter (30) mindestens eine Öffnung (31) aufweist,
das Vergussmaterial (40) durch die Öffnung (31) hindurch einen durchgehenden Wärmeübergang zwischen dem Kondensator (20) und dem Metallformkörper (10) bildet.

13. Verfahren nach einem der Ansprüche 9-12, wobei
der Abstandshalter (30) ein zur passgenauen Aufnahme des Kondensators (20) geformter Hohlkörper.

14. Verfahren nach einem der Ansprüche 9-13, wobei
der Metallformkörper (10) ein wassergekühlter Kühlkörper ist.
